# EUROPEAN PATENT APPLICATION

(11) **EP 0 710 058 A2**
(43) Date of publication of application: **01.05.1996**
(21) Application number: 95307194.1
(22) Date of filing: 11.10.1995
(51) Int. Cl.: H05K 1/02

(54) **Inhibiting short-circuits between electrically conductive paths**

(30) Priority: 14.10.1994 US 321869
(71) Applicant: SAMSUNG DISPLAY DEVICES CO., LTD., Suwon, Kyonggi-do (KR); ZYMET, INC., East Hanover, New Jersey 07936 (US)
(72) Inventor: Lee, Chang-hoon, Paldal-gu, Suwon, Kyonggi-do (KR); Loh, Karl I., East Hanover, New Jersey 07936 (US)
(74) Representative: Stanley, David William

(57) **Abstract**

An electric device 10 includes an integrated circuit 12 having two conductive paths 18, a conductive adhesive 26, a substrate 14 having two conductive paths 22, each of the two conductive paths 22 of the substrate 14 being connected to a corresponding one of the two conductive paths 18 of the integrated circuit 12 via the conductive adhesive 26 to form two electrical connections, and a peak-shaped dielectric dam 42, formed on the substrate 14 between the two electrical connections, in order to inhibit short-circuiting between the two electrical connections.

## Description

The present invention relates to devices having electrically conductive paths and means for inhibiting short-circuits between such paths. The invention may have particular application to integrated circuits.

Examples of known structures in integrated circuits will now be described, by way of example, with reference to Figures 1 to 4 of the accompanying diagrammatic drawings, in which:
Figure 1 illustrates a first conventional electronic device, which is subject to short circuiting;
Figure 2 illustrates a first conventional approach for solving the short circuiting problem illustrated in Figure 1;
Figures 3A and 3B illustrate a second conventional approach for solving the short circuiting problem illustrated in Figure 1; and
Figure 4 illustrates a third conventional approach for solving the short circuiting problem illustrated in Figure 1.

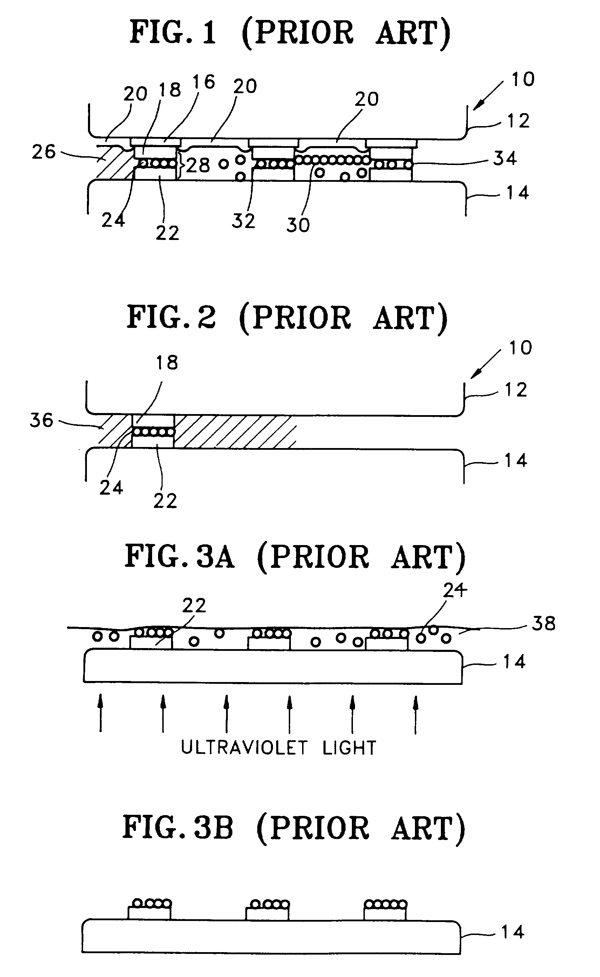

In an electronic device 10, an integrated circuit 12 is attached to a substrate 14, which may be made of glass, as illustrated in Figure 1. The integrated circuit 12 includes aluminum pads 16, gold bumps 18, and a passivation layer 20. The substrate 14 includes patterns 22, which are electrically connected to the gold bumps 18 of the integrated circuit 12 via conductive particles 24 contained in an adhesive 26. The conductive particles 24 may be made of gold, silver, nickel, metal coated glass, metal coated silica, or a metal coated polymer. The conductive particles 24 in the adhesives 26 are trapped between the patterns 22 on the substrate 14 and the gold bumps 18 on the integrated circuit 12 to make electrical connections 28 therebetween. However, the conductive particles 24 may also form a short circuit 30 between a first electrical connection 32 and a second electrical connection 34, thereby causing a short circuit in the electronic device 10.

One approach to solve this short circuiting problem is illustrated in Figure 2. In this approach, the conductive particles 24 are selectively deposited onto the gold bumps 18 on the integrated circuit 12, before attaching the integrated circuit 12 to the substrate 14. The integrated circuit 12 and the substrate 14 are then attached with a non-conductive paste 36. This method is extremely expensive and time consuming, since it is very difficult to place the conductive particles 24 on the gold bumps 18. Further, integrated circuits are not typically sold with conductive particles on the aluminum pads. As a result, this technique is not suitable for mass producing an electronic device, which includes numerous integrated circuits, attached to a substrate.

A second solution to the short circuit problem identified above is illustrated in Figure 3. In this method, the substrate 14 and patterns 22 residing thereon are coated with a positive acting photoimagable photoresist 38, mixed with conductive particles 24, as illustrated in Figure 3A. Ultraviolet light is applied to a back side of the substrate 12 and a portion of the positive acting photoimagable photoresist 38 which is exposed (namely the portions between the patterns 22) washes away, leaving the conductive particles 24 on top of the patterns 22 of the substrate 14, as illustrated in Figure 3B. The substrate 14 is then attached to the integrated circuit 12 using a non-conductive adhesive 36. This technique is also time consuming and expensive, since the positive acting photoimagable photoresist 38 must be carefully applied to the patterns 22 of the substrate 12, in order to ensure that a uniform layer of conductive particles 24 are applied on top of the patterns 22 of the substrate 12. Further, this technique is impractical for large area substrate and is not easily integrated into existing manufacturing processes.

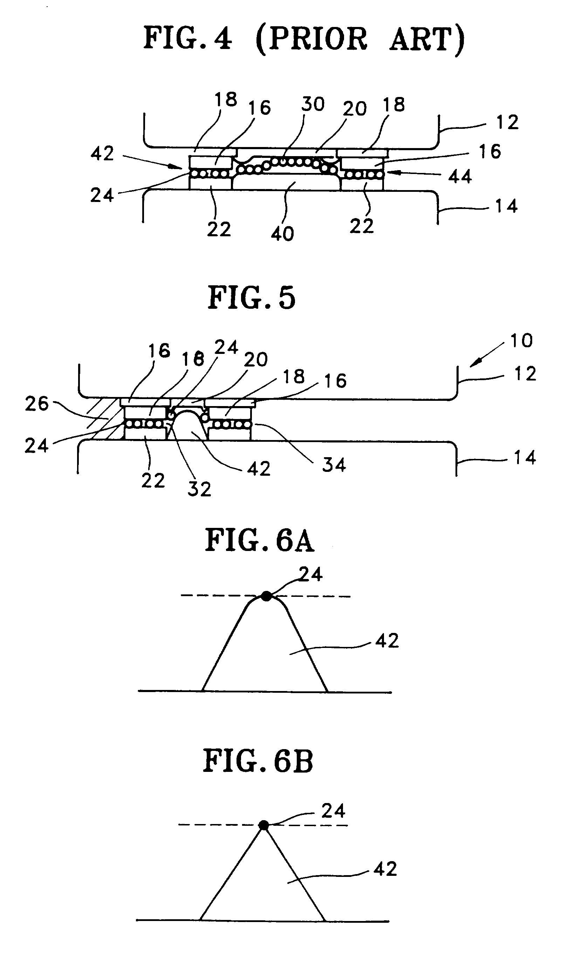

A third technique for solving the short circuiting problem includes the addition of a dielectric barrier 40 between two patterns 22 on the substrate 14, as illustrated in Figure 4. However, in this arrangement, the dielectric barrier 40 is likely to force the conductive particles 24, as illustrated in Figure 4, to form a short-circuit 30 between first and second electrical connections 42 and 44.

Preferred embodiments of the invention described in this specification aim to solve the problem of short circuiting between electrical connections when using an adhesive, by providing a peak-shaped dielectric dam between two electrical connections, in order to minimize the possibility that conductive particles in an adhesive will form a short circuit between the two electrical connections. Preferred embodiments of the present invention also provide a novel method for manufacturing such a peak-shaped dielectric dam, which is fast and inexpensive, and therefore suitable for the mass production of electronic devices, which include numerous interconnections between integrated circuits and substrates.

An aim of preferred embodiments of the present invention is to provide a novel arrangement for minimizing the possibility of an electrical short circuit between two electrical connections of an integrated circuit and substrate, by utilizing a peak-shaped dielectric dam between the two electrical connections. This novel design prevents conductive particles contained in an adhesive which bonds the integrated circuit to the substrate, from forming a short circuit between the two electrical connections by ensuring the conductive particles fall to either side of the peak-shaped dielectric dam.

Another aim of preferred embodiments of the present invention is to provide a novel method of electrically connecting an integrated circuit to a substrate including a peak-shaped dielectric dam, which prevents short circuiting between two electrical connections between the integrated circuit and the substrate. Such a method does not require precise application of a conductive adhesive, and as a result, the method may be performed quickly and cheaply, in order to produce the peak-shaped dielectric dam, which prevents short circuiting.

A further aim of preferred embodiments of the present invention is to provide a novel arrangement for minimizing the possibility of an electrical short circuit between two electrical connections of an integrated circuit and a substrate, by utilizing a sloped dielectric dam between the two electrical connections. This novel design prevents conductive particles contained in an isotropically conductive adhesive which bonds the integrated circuit to the substrate, from forming a short circuit between the two electrical connections by creating a reservoir for displaced isotropically conductive adhesive.

Another aim of preferred embodiments of the present invention is to provide a novel method of electrically connecting an integrated circuit to a substrate including a sloped dielectric dam, which prevents short circuiting between two electrical connections between the integrated circuit and the substrate. Such a method does not require precise application of a conductive adhesive, and as a result, the result may be performed quickly and cheaply, in order to produce the sloped dielectric dam, which prevents short circuiting.

A further aim of preferred embodiments of the present invention is to provide a novel method of maskless imaging of a photoimagable dielectric on a transparent member in order to form a dielectric dam.

According to one aspect of the present invention, there is provided an apparatus comprising:
a first member having two electrically conductive paths;
a second member having two electrically conductive paths;
an electrically conductive adhesive that connects each of the two conductive paths of said first member to a respective one of the two conductive paths of said second member, to form two separate electrical connections ; and
a dielectric member provided between said first and second members and between said two electrical connections, the dielectric member having a portion of increased thickness to define with said first and/or second member, and/or one or more part thereon, a restriction to at least one side of which said adhesive is preferentially disposed, in order to inhibit electrical conduction between said electrical connections by way of said adhesive.

According to another aspect of the present invention, there is provided a method of electrically connecting a first member having two electrically conductive paths and a second member having two electrically conductive paths, said method comprising the steps of:
- (a): providing a dielectric member between said two conductive paths on one of said first and second members; and
- (b): connecting each of the two conductive paths of said first member to a respective one of the two conductive paths of said second member, by means of an electrically conductive adhesive, to form two separate electrical connections:
the dielectric member being thus provided between said first and second members and between said two electrical connections, and the dielectric member having a portion of increased thickness to define with said first and/or second member, and/or one or more part thereon, a restriction to at least one side of which said adhesive is preferentially disposed, in order to inhibit electrical conduction between said electrical connections by way of said adhesive.

Preferably, one of said first and second members is transparent and said two conductive paths of said one member are opaque, said step (a) including the sub-steps of:
applying a negative acting photoimagable dielectric to a conductive path side of said one member; and
projecting light from a back side of said one member, through said one member, to expose said negative photoimagable dielectric residing between said two opaque conductive paths, thereby forming said dielectric member.

Said step (a) may include the sub-steps of:
applying a negative or positive acting photoimagable dielectric to a conductive path side of one of said first and second members; and
projecting light through a mask to expose said negative or positive acting photoimagable dielectric, thereby forming said dielectric member between said two electrical connections.

Preferably, said dielectric member has a sloping profile, such that it increases in thickness towards said portion of increased thickness.

Preferably, said dielectric member has two sloping portions that meet at a peak at said portion of increased thickness.

Said dielectric member may be provided on said first member.

Said dielectric member may be provided on said second member.

Said adhesive may be an isotropically conductive adhesive.

Said electrically conductive adhesive may be an anisotropically conductive adhesive, including monosize conductive particles.

Said dielectric member may be provided on one of said first and second members, and a distance from said portion of increased thickness of said dielectric member to the other of said first and second members, a particle distribution of said monosize conductive particles, and a shape of said monosize conductive particles may be selected such that said dielectric member fully electrically insulates said two electrical connections from one another.

Said dielectric member may be deformed by pressed against one of said first and second members.

A shape of said monosize conductive particles may prevent any of said monosize conductive particles from being positioned between said portion of increased thickness of said dielectric member and one of said first and second members.

At least one of said first and second members may be one of the group comprising a flip chip integrated circuit, a tape-automated bonded integrated circuit, a flexible circuit, a glass panel, a printed circuit board, a multi-chip module substrate and a hybrid circuit substrate.

Said first member may be a liquid crystal display driver integrated circuit and said second member a glass panel.

According to a further aspect of the present invention, there is provided a method of maskless imaging of a negative photoimagable dielectric on a transparent member including two opaque areas, said method comprising the steps of:
- (a): applying said negative photoimagable dielectric to an opaque area side of said transparent member; and
- (b): projecting light from a back side of said transparent member, through said transparent member, to expose said negative photoimagable dielectric residing between said two opaque areas, thereby imaging said negative photoimagable dielectric to form a dielectric member.

One of said two opaque areas may be a non-active conductive opaque area or a non-conductive opaque area.

For a better understanding of the invention, and to show how embodiments of the same may be carried into effect, reference will now be made, by way of example, to Figures 5 to 10 of the accompanying diagrammatic drawings, in which:
Figure 5 illustrates one example of apparatus in accordance with a preferred embodiment of the present invention;
Figures 6A and 6B illustrate two examples of the shape of a peak-shaped dielectric dam illustrated in Figure 5;

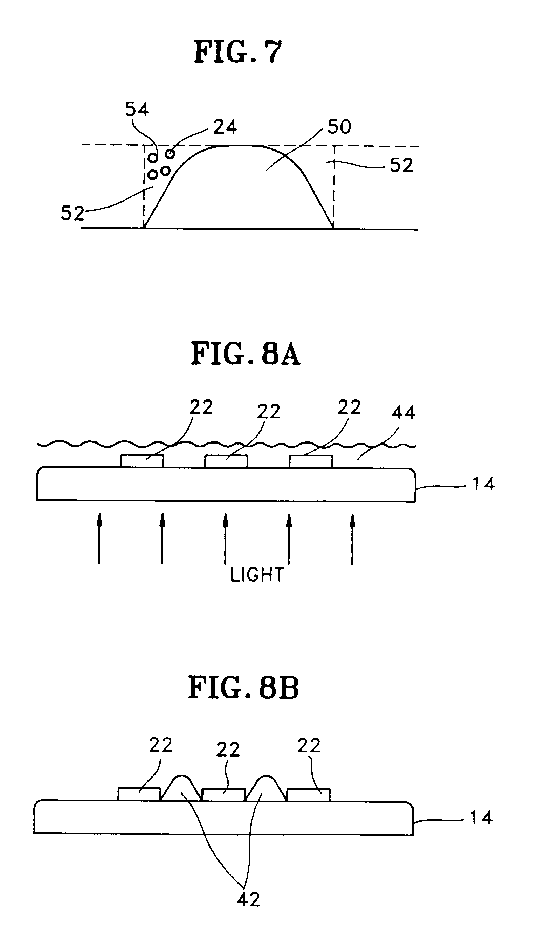

Figure 7 illustrates an example of the shape of a sloped dielectric dam in another embodiment of the present invention;
Figures 8A and 8B illustrate one example of a method of forming the peak-shaped dielectric dam illustrated in Figure 5;

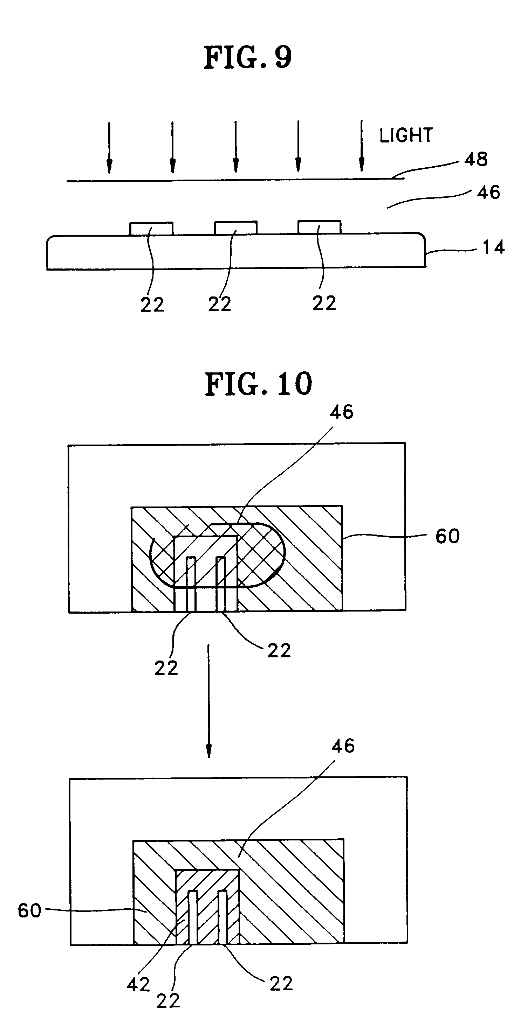

Figure 9 illustrates another example of a method of forming the peak-shaped dielectric dam illustrated in Figure 5; and
Figure 10 illustrates another example of a method of forming a peak-shaped dielectric dam between a conductive path and a non-conductive path.

In the figures, like reference numerals denote like or corresponding parts.

Preferred embodiments of the present invention are directed to a novel apparatus including a peak-shaped dielectric dam and a method of manufacturing such a peak-shaped dielectric dam, in order to minimize the possibility that conductive particles in an adhesive will form a short circuit between two electrical connections between an integrated circuit and a substrate. Preferred embodiments of methods of the present invention for manufacturing such peak-shaped dielectric dams are fast and inexpensive, and therefore suitable for the mass production of electronic devices, which include numerous interconnections between integrated circuits and substrates.

Figure 5 illustrates a preferred embodiment of the present invention. In an electronic device 10, an integrated circuit 12 is attached to a substrate 14. The integrated circuit 12 includes aluminum pads 16 and gold bumps 18, and the substrate 14 includes patterns 22, which are to be electrically connected with the gold bumps 18, via conductive particles 24 of an adhesive 26. In this preferred embodiment, a peak-shaped dielectric dam 42 is formed on the substrate 14 between a first electrical connection 32 and a second electrical connection 34, in order to minimize the possibility of a short circuit between the first electrical connection 32 and the second electrical connection 34. The shape of the peak-shaped dielectric dam 42 prevents conductive particles 24 from resting at the peak of the peak-shaped dielectric dam 42, and therefore minimizes the possibility of a short circuit.

In another preferred embodiment, the peak-shaped dielectric dam 42 is formed on the integrated circuit 12 instead of on the substrate 14. In another preferred embodiment, either the integrated circuit 12 or substrate 14 is a flip chip integrated circuit, a tape-automated bonded (TAB) integrated circuit, flexible circuit, a glass panel, a printed circuit board, a multi-chip module substrate, or a hybrid circuit substrate.

In another preferred embodiment of the present invention, the integrated circuit 12 is a liquid crystal display driver integrated circuit and the substrate 14 is a glass panel. In another preferred embodiment, the adhesive 26 is an anisotropically or isotropically conductive adhesive.

In another preferred embodiment of the present invention, the peak-shaped dielectric dam has a shape as illustrated in Figure 6A or 6B, such that a conductive particle 24 disposed at the peak of the peak-shaped dielectric dam 42 will be prevented from resting there, therefore minimizing the possibility of a short circuit.

In yet another preferred embodiment, the conductive particles 24 are monosize, being spherical or ovoid in shape. In yet another preferred embodiment, monosize conductive particles 24 are irregular, rough-surfaced particles, or particles with flat surfaces.

In another preferred embodiment of the present invention, the adhesive 26 is an anisotropically conductive adhesive which includes conductive particles 24 which are monosize. The conductive particles 24 may have a diameter of the order of a few tens of microns. In yet another preferred embodiment, the monosize particles have a diameter variance of ±10 µm or less and a particle distribution such that most of the monosize conductive particles 24 have diameters in this range.

In another embodiment, the peak-shaped dielectric dam 42 is formed such that a distance between a peak of the peak-shaped dielectric dam 42 and a passivation layer 20 on the integrated circuit 12, a particle distribution of monosize conductive particles 24, and a shape of the monosize conductive particles 24 are so selected as to ensure that no short circuit is formed between the first electrical connection 32 and the second electrical connection 34.

In yet another preferred embodiment of the present invention, a distance from a peak of the peak-shaped dielectric dam 42 to the first substrate, a particle distribution of monosize conductive particles, and a shape of the monosize conductive particles are selected such that the peak-shaped dielectric dam fully insulates the two electrical connections 32 and 34 and prevents a short circuit. In the event that the integrated circuit 12 also includes a passivation layer 20 as illustrated in Figure 1, then the distance from the peak of the peak-shaped dielectric dam 42 to the passivation layer 20 on the integrated circuit 12, the particle distribution of the monosize conductive particles, and the shape of a monosize conductive particles are selected such that the peak-shaped dielectric dam 42 fully insulates the first electrical connection 32 and the second electrical connection 34 and prevents a short circuit.

In the embodiment of Figure 5, it is physically impossible for one of the conductive particles 24 to reside between the peak of the peak-shaped dielectric dam 42 and the integrated circuit 12 or its passivation layer 20. As a result, the peak-shaped dielectric dam 42 fully insulates the first electrical connection 32 from the second electrical connection 34.

In another preferred embodiment of the present invention, a distance from the peak-shaped dielectric dam 42 to the integrated circuit 12 or a passivation layer on the integrated circuit 12, the particle distribution of monosize conductive particles, and the shape of the monosize conductive particles are so selected that, although it may be physically possible for a particle to fit in the space between the peak of the peak-shaped dielectric dam 42 and the integrated circuit 12 or its passivation layer 20, the shape of the peak-shaped dielectric dam 42 reduces the possibility that one of the conductive particles 24 will reside at the peak of the peak-shaped dielectric dam 42, thereby reducing the possibility of a short circuit between the first and second electrical connections 32 and 34.

In another preferred embodiment of the present invention, the peak of the peak-shaped dam 42 deforms when the integrated circuit 12 and the substrate 14 are placed together. This configuration also fully insulates the first electrical connection 32 from the second electrical connection 34.

In another preferred embodiment of the present invention, a sloped dielectric dam 50, illustrated in Figure 7 is formed between the two electrical connections 32 and 34. The sloped dielectric dam 50 defines areas 52, which act as reservoirs for an anisotropically conductive adhesive 54, which is displaced by the sloped dielectric dam 50, when the sloped dielectric dam 50, formed on the substrate 14, is brought into contact with the integrated circuit 12.

An example of a method of manufacturing a peak-shaped dielectric dam as illustrated in Figure 5, is illustrated in Figure 8A. A negative acting photoimagable dielectric 44 is applied to a conductive path side or front side of the substrate 14. Light is then projected from an opposite side or back side of the substrate 14. The light exposes the negative acting photoimagable dielectric 44 residing between the patterns 22 on the substrate 14. The non-exposed negative acting photoimagable dielectric 44 on top of the patterns 22 is developed, leaving the structure illustrated in Figure 8B, including the peak-shaped dielectric dam 42.

In another preferred embodiment, a peak-shaped dielectric dam 42 is formed as illustrated in Figure 9. A negative or positive acting photoimagable dielectric 46 is applied to a conductive path side or front side of the substrate 14. Light is then projected through a mask 48 to expose the negative or positive acting photoimagable dielectric 46, in order to form the peak-shaped dielectric dam 42.

In the preferred embodiment illustrated in Figure 7, each of the patterns 22 is a conductive path. However, a peak-shaped dielectric dam 42 may also be formed between one pattern 22 which is conductive and another opaque area which is either non-active and conductive or non-conductive. Such an embodiment is illustrated in Figure 10. Figure 10 illustrates two patterns 22 which are conductive on the substrate 14 as well as an opaque area 60. A negative or positive acting photoimagable dielectric 46 is placed on the opaque area 60 over portions of the patterns 22 which are conductive. The negative or positive acting photoimagable dielectric 46 is then exposed such that a peak-shaped dielectric dam 42 is formed between the patterns 22 which are conductive and a peak-shaped dielectric dam 42 is also formed between the patterns 22 which are conductive and the opaque area 60. This opaque area 60 may be either a non-active conductive opaque area or a non-conductive opaque area.

Examples of the invention having been thus described, it will be apparent that the same may be varied in many ways. Such variations are not to be regarded as a departure from the spirit and scope of the invention, and all such modifications as would be obvious to one skilled in the art are intended to be included within the scope of the following claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An apparatus (10) comprising:
a first member (12) having two electrically conductive paths (16,18);
a second member (14) having two electrically conductive paths (22);
an electrically conductive adhesive (26) that connects each of the two conductive paths (16,18) of said first member (12) to a respective one of the two conductive paths (22) of said second member (14), to form two separate electrical connections (32,34) ; and
a dielectric member (42) provided between said first and second members (12,14) and between said two electrical connections (32,34), the dielectric member (42) having a portion of increased thickness to define with said first and/or second member (12,14), and/or one or more part (20) thereon, a restriction to at least one side of which said adhesive (26) is preferentially disposed, in order to inhibit electrical conduction between said electrical connections (32,34) by way of said adhesive (26).

2. A method of electrically connecting a first member (12) having two electrically conductive paths (16,18) and a second member (14) having two electrically conductive paths (22), said method comprising the steps of:
(a) providing a dielectric member (42) between said two conductive paths on one of said first and second members (12,14); and
(b) connecting each of the two conductive paths (16,18) of said first member (12) to a respective one of the two conductive paths (22) of said second member (14), by means of an electrically conductive adhesive (26), to form two separate electrical connections (32,34):
the dielectric member (42) being thus provided between said first and second members (12,14) and between said two electrical connections (32,34), and the dielectric member (42) having a portion of increased thickness to define with said first and/or second member (12,14), and/or one or more part (20) thereon, a restriction to at least one side of which said adhesive (26) is preferentially disposed, in order to inhibit electrical conduction between said electrical connections (32,34) by way of said adhesive (26).

3. A method according to claim 2, wherein one of said first and second members (14) is transparent and said two conductive paths (22) of said one member (14) are opaque, said step (a) including the sub-steps of:
applying a negative acting photoimagable dielectric (44) to a conductive path side (front side) of said one member (14); and
projecting light from a back side of said one member (14), through said one member (14), to expose said negative photoimagable dielectric (44) residing between said two opaque conductive paths (22), thereby forming said dielectric member (42).

4. A method according to claim 2, wherein said step (a) includes the sub-steps of:
applying a negative or positive acting photoimagable dielectric (46) to a conductive path side (front side) of one of said first and second members (14); and
projecting light through a mask (48) to expose said negative or positive acting photoimagable dielectric (46), thereby forming said dielectric member (42) between said two electrical connections (32,34).

5. An apparatus or method according to any of the preceding claims, wherein said dielectric member (42) has a sloping profile, such that it increases in thickness towards said portion of increased thickness.

6. An apparatus or method according to claim 5, wherein said dielectric member (42) has two sloping portions that meet at a peak at said portion of increased thickness.

7. An apparatus or method according to any of the preceding claims, wherein said dielectric member (42) is provided on said first member (12).

8. An apparatus or method according to any of claims 1 to 6, wherein said dielectric member (42) is provided on said second member (12).

9. An apparatus or method according to any of the preceding claims, wherein said adhesive (26) is an isotropically conductive adhesive.

10. An apparatus or method according to any of claims 1 to 8, wherein said electrically conductive adhesive (26) is an anisotropically conductive adhesive, including monosize conductive particles (24).

11. An apparatus or method according to claim 10, wherein said dielectric member (42) is provided on one of said first and second members (12,14), and a distance from said portion of increased thickness of said dielectric member (42) to the other of said first and second members (12,14), a particle distribution of said monosize conductive particles (24), and a shape of said monosize conductive particles (24) are selected such that said dielectric member (42) fully electrically insulates said two electrical connections (32,34) from one another.

12. An apparatus or method according to any of the preceding claims, wherein said dielectric member (42) is deformed by pressed against one of said first and second members (12,14).

13. An apparatus or method according to claim 10 or 11, wherein a shape of said monosize conductive particles (24) prevents any of said monosize conductive particles (24) from being positioned between said portion of increased thickness of said dielectric member (42) and one of said first and second members (12,14).

14. An apparatus or method according to any of the preceding claims, wherein at least one of said first and second members (12,14) is one of the group comprising a flip chip integrated circuit, a tape-automated bonded (TAB) integrated circuit, a flexible circuit, a glass panel, a printed circuit board, a multi-chip module substrate and a hybrid circuit substrate.

15. An apparatus or method according to any of claims 1 to 13, wherein said first member (12) is a liquid crystal display driver integrated circuit and said second member (14) is a glass panel.

16. A method of maskless imaging of a negative photoimagable dielectric (44) on a transparent member (14) including two opaque areas (22), said method comprising the steps of:
(a) applying said negative photoimagable dielectric (44) to an opaque area side (front side) of said transparent member (14); and
(b) projecting light from a back side of said transparent member (14), through said transparent member (14), to expose said negative photoimagable dielectric (46) residing between said two opaque areas (22), thereby imaging said negative photoimagable dielectric (46) to form a dielectric member (42).

17. A method according to claim 16, wherein one of said two opaque areas (22) is a non-active conductive opaque area or a non-conductive opaque area.
